# DEMANDE DE BREVET EUROPEEN

(11) **EP 2 796 948 A1**
(43) Date de publication de la demande: **29.10.2014**
(21) Numéro de dépôt: 13164968.3
(22) Date de dépôt: 23.04.2013
(51) Int. Cl.: G04G 21/08, G06F 3/044, H03K 17/94

(54) **Procédé de gestion des manipulations d'un appareil électronique**

(71) Demandeur: ETA SA Manufacture Horlogère Suisse, 2540 Grenchen (CH)
(72) Inventeur: Bovet, Jean-Luc, 4500 Solothurn (CH); Jufer, Martin, 4917 Melchnau (CH); Nussbaum, André, 2504 Bienne (CH); Christe, Laurent, 2504 Bienne (CH)
(74) Mandataire: Ravenel, Thierry Gérard Louis

(57) **Abrégé**

L'invention concerne un appareil électronique (1) comprenant un boîtier (2) muni d'une glace et d'un fond, ledit appareil électronique comprenant au moins un module électronique (6) agencé pour calculer l'heure courante, exécuter plusieurs fonctions et fournir des informations liées à l'heure courante et à ces fonctions à des moyens d'affichage (3) disposés sous la glace, l'appareil électronique comportant des moyens de commande (5) comprenant au moins une zone de contact (P1) permettant à l'utilisateur d'agir sur ledit au moins un module électronique, cette au moins une zone de contact étant surveillée par le module électronique à une fréquence de balayage.

## Description

L'invention concerne un appareil électronique comprenant un boîtier comprenant une glace et un fond, ledit appareil électronique comprenant au moins un module électronique agencé pour pouvoir exécuter plusieurs fonctions et fournir des informations liées à ces fonctions à des moyens d'affichage disposés sous la glace et des moyens de commande comprenant au moins deux zones de contact sur lesquelles l'utilisateur peut appuyer pour agir sur ledit au moins un module électronique.

### ARRIERE PLAN TECHNOLOGIQUE

Il est connu des appareils électroniques comprenant un écran LCD tactile utilisé pour activer les différentes fonctions de l'appareil.

Par exemple, il est connu des montres comprenant une glace dite tactile présentant sur sa face inférieure des électrodes capacitives servant de touches tactiles. Ces touches sont activées par un poussoir classique. Cette activation des touches tactiles consiste à les balayer. Cela signifie que chaque touche est surveillée à une certaine fréquence pour voir si un appui c'est à dire une variation de capacité a lieu. Pour détecter les différentes appuis et différentes manipulations tactiles, une fréquence de balayage élevée de l'ordre de 64Hz est utilisée. L'utilisateur touche alors l'endroit d'une électrode capacitive pour activer la fonction désirée.

Un inconvénient de cette méthode est que l'utilisateur doit préalablement activer les touches tactiles avant de sélectionner une fonction et donc cela nécessite une manipulation supplémentaire. De plus, cette configuration nécessite d'avoir une touche pour activer une fonction ce qui limite par conséquent le nombre de fonction que l'appareil peut avoir.

Il est également connu des appareils électroniques munis d'un écran tactile. Cet écran tactile est en permanence activé de sorte qu'à chaque instant, l'utilisateur puisse manipuler l'appareil électronique tactile. Cela signifie que la totalité des touches tactiles sont balayés à une fréquence élevée. Si cela permet de procurer à l'utilisateur un confort lors des manipulations, cette configuration a aussi l'inconvénient d'être gourmande en énergie électrique. En effet, ce balayage permanent nécessite une utilisation continu du microprocesseur ou microcontrôleur qui gère l'affichage tactile. Il en ressort un consommation d'énergie électrique importante.

### RESUME DE L'INVENTION

L'invention a pour but de pallier les inconvénients de l'art antérieur en proposant de fournir un appareil électronique offrant un bon confort d'utilisation tout en étant économe en énergie électrique.

A cet effet, l'invention concerne un appareil électronique comprenant un boîtier muni d'une glace et d'un fond, ledit appareil électronique comprenant au moins un module électronique agencé pour calculer l'heure courante, exécuter plusieurs fonctions et fournir des informations liées à l'heure courante et à ces fonctions à des moyens d'affichage disposés sous la glace, l'appareil électronique comportant des moyens de commande comprenant au moins une zone de contact permettant à l'utilisateur d'agir sur ledit au moins un module électronique, cette au moins une zone de contact étant surveillée par le module électronique à une fréquence de balayage, **caractérisé en ce que** le module électronique est agencé pour fonctionner dans un premier mode de fonctionnement dans lequel l'heure courante est affichée et dans lequel la au moins une zone de contact est surveillée à une première fréquence de balayage et pour fonctionner dans un second mode de fonctionnement dans lequel les fonctions sont activables par l'utilisateur et dans lequel la au moins une zone de contact est surveillée à une seconde fréquence de balayage supérieure à la première fréquence de balayage.

Dans un premier mode de réalisation avantageux, les moyens de commande comprenant au moins deux zones de contact.

Dans un second mode de réalisation avantageux, le passage du premier mode de fonctionnement au second mode de fonctionnement se fait par un contact sur au moins une zone de contact.

Dans un troisième mode de réalisation avantageux, les moyens de commande comprenant trois zones de contact.

Dans un quatrième mode de réalisation avantageux, le passage du premier mode de fonctionnement au second mode de fonctionnement se fait par détection d'un contact sur deux des au moins deux zones de contact.

Dans un autre mode de réalisation avantageux, la première fréquence de balayage est comprise dans un intervalle de 1 Hz à 6Hz.

Dans un autre mode de réalisation avantageux, la première fréquence de balayage est de 2Hz.

Dans un autre mode de réalisation avantageux, la seconde fréquence de balayage est comprise dans un intervalle de 30Hz à 100Hz.

Dans un autre mode de réalisation avantageux, la seconde fréquence de balayage est de 64Hz.

Dans un autre mode de réalisation avantageux, ledit appareil est une montre.

### BREVE DESCRIPTION DES FIGURES

Les buts, avantages et caractéristiques de l'appareil électronique selon la présente invention apparaîtront plus clairement dans la description détaillée suivante d'au moins une forme de réalisation de l'invention donnée uniquement à titre d'exemple non limitatif et illustrée par les dessins annexés sur lesquels :
- La figure 1 représente une vue de dessus de l'appareil électronique selon l'invention ;
- La figure 2 représente une diagramme d'étape de la gestion de l'appareil électronique selon l'invention ;
- La figure 3 représente schématiquement un appareil électronique selon l'invention.

### DESCRIPTION DETAILLEE

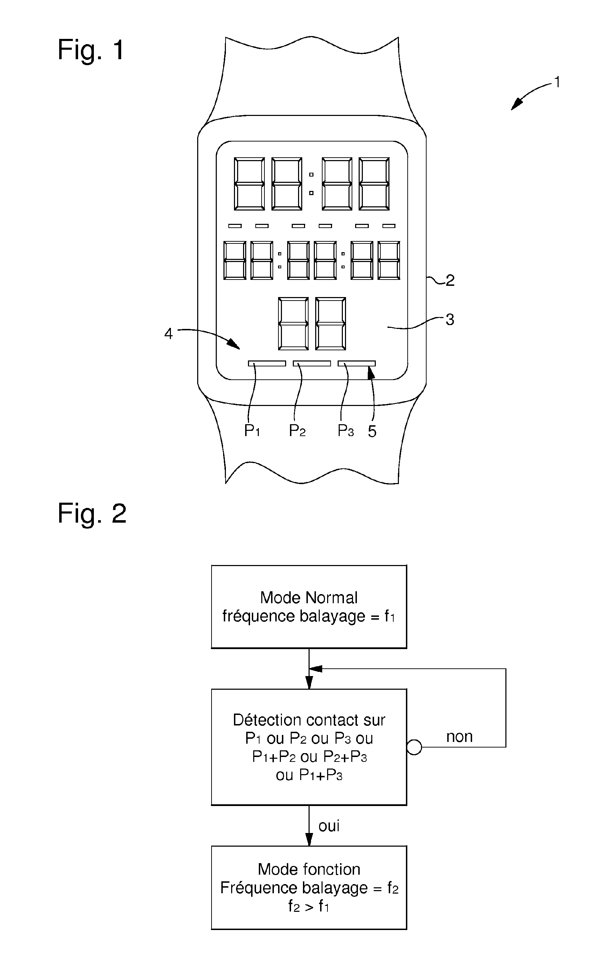

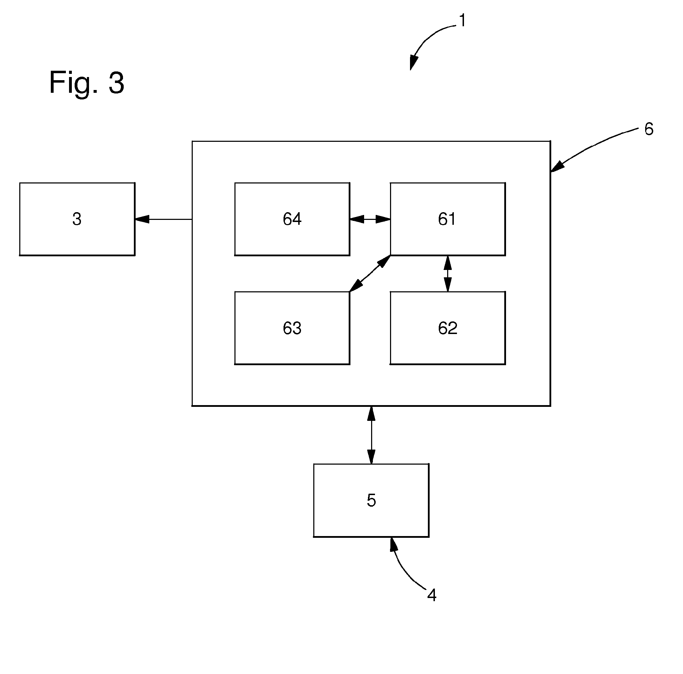

Sur les figures 1 et 3, un objet portable 1 selon l'invention est représenté. Cet objet portable est un appareil électronique qui peut être une montre ou un téléphone ou un ordinateur ou une tablette tactile ou n'importe quel appareil tactile. Cet appareil comprend un boîtier 2 muni d'une glace et d'un fond. L'appareil électronique comprend en outre au moins un module électronique 6. Ce module électronique 6 est agencé pour exécuter plusieurs fonctions et fournir des informations liées à ces fonctions à des moyens d'affichage 3 disposés sous la glace. Le module électronique 6 peut comprendre un microcontrôleur 61 coopérant avec une base de temps 62, une mémoire 64 et différents capteur 63 pour fournir des informations de temps, de pression, de température.

Pour une montre, le module électronique 6 est agencé pour, dans un mode de fonctionnement normal, afficher l'heure courante. Dans un mode de fonctionnement additionnel, le module électronique est agencé pour exécuter l'une des fonctions disponibles, l'utilisateur choisissant la fonction désirée.

Pour contrôler ledit appareil électronique, des moyens de commande 4 sont agencés. Ces moyens de commandes 4 sont agencés au niveau de la glace ou du boîtier 2. Ces moyens de commande 4 sont des moyens de commandes tactiles 5 c'est-à-dire qu'ils réagissent aux actions des doigts de l'utilisateur. De tels moyens de commande tactiles 5 sont capacitifs c'est-à-dire qu'une électrode est placée sous la glace ou sous le boîtier 2. Le contact du doigt de l'utilisateur sur la glace ou le boîtier 2 au niveau de l'électrode entraine une variation de la capacité. Cette variation de la capacité est détectée et est interprétée par le module électronique.

Pour l'objet portable selon l'invention, les moyens de commande 5 comprennent au moins une zone de contact P1 aussi appelée touche tactile sur laquelle l'utilisateur entrer en contact pour agir sur ledit au moins un module électronique. Préférentiellement, les moyens de commande comprennent au moins deux zones de contacts et encore plus préférentiellement trois zones de contact P1, P2 et P3.

Avantageusement, l'invention prévoit que la gestion de ces moyens de commande tactiles 6 soit confortable pour l'utilisateur et économe en électricité.

Pour cela, le module électronique 3 est agencé pour fonctionner selon deux modes de fonctionnement différents comme visible à la figure 2. Le module électronique 3 est agencé pour fonctionner selon un premier mode de fonctionnement dit normal dans lequel l'heure courante est affiché et selon un second mode de fonctionnement dit de fonction dans lequel l'utilisateur peut activer les diverses fonctions de l'appareil.

Dans le premier mode de fonctionnement, le module électronique 3 balaye les touches tactiles à une premier fréquence f1. De préférence, cette fréquence est choisie dans un intervalle de 1 à 6 Hz. Préférentiellement, une fréquence de 2Hz est choisie. Cette fréquence est faible et, par conséquent, peu gourmande en énergie électrique.

Dans ce premier mode de fonctionnement, la seule fonction active et celle de l'heure courante de sorte qu'aucune autre fonction ne peut être choisie et activée. Ainsi, aucune manipulation complexe sur les touches tactiles n'est requise. Cette première fréquence f1 est alors utilisée pour le passage du premier mode de fonctionnement au second mode de fonctionnement.

Pour passer au second mode de fonctionnement , un simple contact sur au moins l'une des touches tactiles doit être détecté. Ce contact peut être un appui ou un effleurement. Comme il s'agit d'un simple contact, cela ne nécessite pas de fréquence de balayage élevé et une faible fréquence de balayage suffit pour détecter un tel contact. On comprend que lors d'un contact avec une ou deux touches tactiles, le module électronique 3 détecte ce contact et engage le passage du premier mode de fonctionnement au second mode de fonctionnement.

Le second mode de fonctionnement permettant d'activer les autres fonctions de l'appareil électronique se caractérise par une seconde fréquence de balayage f2. Cette seconde fréquence de balayage f2 est choisie supérieure à la première fréquence de balayage f1 qui est la fréquence de balayage du premier mode de fonctionnement.

De préférence, cette seconde fréquence de balayage f2 est choisie dans un intervalle de 30 à 100Hz et de préférence cette fréquence est de 64Hz.

Cette seconde fréquence de balayage f2 est élevée car elle doit permettre des manipulations complexes comme la détection d'un doigt qui active les différentes touches tactiles les unes à la suite des autres ou des appuis rapides.

Effectivement, lors de manipulation complexe telle une activation successive des différentes touches appelée aussi « slide » ou glissement, l'intervalle de temps entre deux contacts sur les touches tactiles par les doigts de l'utilisateur se raccourcit. De ce fait, la détection de l'appui doit être fiable. En augmentant la fréquence de balayage, la durée entre deux surveillances de la capacité d'une touche tactile est réduite. Cette durée réduite entre deux surveillances entraîne une détection plus facile des appuis rapides tout en diminuant les risques d'erreurs.

Par conséquent, le module électronique optimise la consommation électrique et le confort d'utilisation en permettant d'avoir un écran d'affichage en permanence activée tout en limitant la consommation électrique.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. Appareil électronique (1) comprenant un boîtier (2) muni d'une glace et d'un fond, ledit appareil électronique comprenant au moins un module électronique (6) agencé pour calculer l'heure courante, exécuter plusieurs fonctions et fournir des informations liées à l'heure courante et à ces fonctions à des moyens d'affichage (3) disposés sous la glace, l'appareil électronique comportant des moyens de commande (5) comprenant au moins une zone de contact (P1) permettant à l'utilisateur d'agir sur ledit au moins un module électronique, cette au moins une zone de contact étant surveillée par le module électronique à une fréquence de balayage, **caractérisé en ce que** le module électronique est agencé pour fonctionner dans un premier mode de fonctionnement dans lequel l'heure courante est affichée et dans lequel la au moins une zone de contact est surveillée à une première fréquence de balayage (f1) et pour fonctionner dans un second mode de fonctionnement dans lequel les fonctions sont activables par l'utilisateur et dans lequel la au moins une zone de contact est surveillée à une seconde fréquence de balayage (f2) supérieure à la première fréquence de balayage.

2. Appareil électronique selon la revendication 1, **caractérisé en ce que** les moyens de commande (5) comprenant au moins deux zones de contact (P1, P2).

3. Appareil électronique selon les revendications 1 ou 2, **caractérisé en ce que** le passage du premier mode de fonctionnement au second mode de fonctionnement se fait par un contact sur au moins une zone de contact.

4. Appareil électronique selon la revendication 1, **caractérisé en ce que** les moyens de commande (5) comprenant trois zones de contact (P1, P2).

5. Appareil électronique selon la revendication 1, **caractérisé en ce que** le passage du premier mode de fonctionnement au second mode de fonctionnement se fait par détection d'un contact sur deux des au moins deux zones de contact.

6. Appareil électronique selon l'une des revendications précédentes, **caractérisé en ce que** la première fréquence de balayage est comprise dans un intervalle de 1 Hz à 6Hz.

7. Appareil électronique selon la revendication 6, **caractérisé en ce que** la première fréquence de balayage est de 2Hz.

8. Appareil électronique selon l'une des revendications 1 à 5, **caractérisé en ce que** la seconde fréquence de balayage est comprise dans un intervalle de 30Hz à 100Hz.

9. Appareil électronique selon la revendication 8, **caractérisé en ce que** la seconde fréquence de balayage est de 64Hz.

10. Appareil électronique selon la revendication 1, **caractérisé en ce que** ledit appareil est une montre.
